(19) Europäisches Patentamt
European Patent Office
Office européen des brevets

(11) **EP 4 210 099 A1**

(12) **EUROPEAN PATENT APPLICATION**

(43) Date of publication:
**12.07.2023 Bulletin 2023/28**

(21) Application number: **22209061.5**

(22) Date of filing: **23.11.2022**

(51) International Patent Classification (IPC):
***H01L 23/498*** (2006.01)   ***H01L 23/66*** (2006.01)
***H01L 23/552*** (2006.01)

(52) Cooperative Patent Classification (CPC):
(C-Sets available)
**H01L 23/552; H01L 23/49822; H01L 23/49827;**
**H01L 23/66; H05K 1/0228;** H01L 23/49816;
H01L 23/49838; H01L 24/16; H01L 2224/16225;
H01L 2224/16235; H01L 2924/00014;
H01L 2924/15173; H01L 2924/15174;
H01L 2924/15311; H01L 2924/181;   (Cont.)

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **24.12.2021 US 202117561892**

(71) Applicant: **Intel Corporation**
**Santa Clara, CA 95054 (US)**

(72) Inventors:
• **LI, Xiang**
**Portland, 97229 (US)**
• **VERGIS, George**
**Portland, 97229 (US)**
• **MCCALL, James A.**
**Portland, 97229 (US)**

(74) Representative: **Rummler, Felix et al**
**Maucher Jenkins**
**Seventh Floor Offices**
**Artillery House**
**11-19 Artillery Row**
**London SW1P 1RT (GB)**

(54) **PACKAGE ROUTING FOR CROSSTALK REDUCTION IN HIGH FREQUENCY COMMUNICATION**

(57)   An integrated circuit package includes a substrate with traces for high speed communication that are subject to crosstalk. The traces include overlapping pads on different layers of the substrate, which can increase the mutual capacitance of the signal lines, which will offset the mutual inductance. Thus, the overlapping pads can reduce the crosstalk between the signal traces.

**FIG. 1A**

EP 4 210 099 A1

(52) Cooperative Patent Classification (CPC): (Cont.)
H01L 2924/1815; H05K 1/0216; H05K 1/114;
H05K 1/165; H05K 2201/09227;
H05K 2201/09672

C-Sets
H01L 2924/00014, H01L 2224/13099;
H01L 2924/181, H01L 2924/00012

## Description

<u>FIELD</u>

Descriptions are generally related to integrated circuits, and more particular descriptions are related to trace routing for integrated circuit packaging.

## BACKGROUND

Integrated circuits continue to get smaller in size even as operating frequencies rise. As integrated circuits transmit signal across signal traces, they generate electrical fields and magnetic fields. With higher communication frequencies and smaller physical distances, crosstalk can negatively impact signal transmission. Crosstalk refers to energy coupling from one signal line to an adjacent signal line due to the interaction of the electrical and magnetic fields created by the signal lines.

As a specific example, consider memory components, where the memory bandwidth can be constrained by the impact crosstalk has on system margin. The bit detection margin can be comparable in signal strength to the energy coupling between adjacent lines, increasing the risk of bit errors.

Traditionally, crosstalk reduction in memory systems has been accomplished through flip chip bonding to replace wire bond connections, which eliminates many signal lines, reducing crosstalk. Another traditional approach is to use a multilayer substrate with trace routing on multiple different layers with PTH (plated through-hole) connections to transition between different layers. Due to package size limitation and layer count limitation, the use of multilayer layouts does not reduce the crosstalk enough between signals to eliminate the crosstalk.

## BRIEF DESCRIPTION OF THE DRAWINGS

The following description includes discussion of figures having illustrations given by way of example of an implementation. The drawings should be understood by way of example, and not by way of limitation. As used herein, references to one or more examples are to be understood as describing a particular feature, structure, or characteristic included in at least one implementation of the invention. Phrases such as "in one example" or "in an alternative example" appearing herein provide examples of implementations of the invention, and do not necessarily all refer to the same implementation. However, they are also not necessarily mutually exclusive.

    Figure 1A is a block diagram of an example of a system with adjacent traces that have overlapping pads.
    Figure 1B is a side view of the system of Figure 1A.
    Figure 2A is a representation of an example of a trace with an extra pad.
    Figure 2B is a representation of an example of a trace with an extra pad to use with the trace of Figure 2A.
    Figure 2C is a representation of an example of the traces of Figure 2A and Figure 2B.
    Figure 3 is a representation of a trace layout.
    Figure 4 is a representation of voltage response versus time for different trace layouts.
    Figure 5 is a flow diagram of an example of a process for creating a substrate having traces with overlapping pads.
    Figure 6 is a block diagram of an example of a memory subsystem in which trace routing with overlapping pads can be implemented.
    Figure 7 is a block diagram of an example of a computing system in which trace routing with overlapping pads can be implemented.
    Figure 8 is a block diagram of an example of a mobile device in which trace routing with overlapping pads can be implemented.
    Figure 9 is a block diagram of an example of a multi-node network in which trace routing with overlapping pads can be implemented.

Descriptions of certain details and implementations follow, including non-limiting descriptions of the figures, which may depict some or all examples, and well as other potential implementations.

## DETAILED DESCRIPTION

As described herein, an integrated circuit package includes a substrate with traces for high speed communication or high frequency communication that are subject to crosstalk. The package includes overlapping pads on different layers of the substrate for traces of adjacent signals. The overlapping pads can increase the mutual capacitance of the signal lines, which will offset the mutual inductance. Thus, the overlapping pads can reduce the crosstalk between the signal traces.

The inclusion of the overlapping pads can be considered an approach to routing of the traces on the substrate. The changing of the routing as described can have a significant reduction in crosstalk, without increasing system cost, or only by a negligible cost. Examples below repeatedly mention memory or memory systems. It will be understood that signal routing for components other than memory subsystem components can be implemented with overlapping traces.

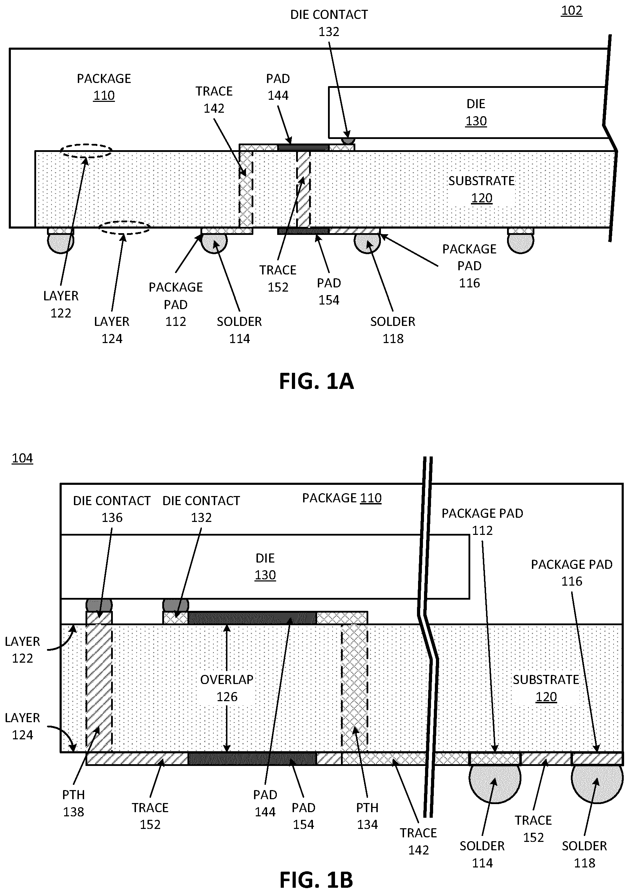

Figure 1A is a block diagram of an example of a system with adjacent traces that have overlapping pads. System 102 represents an integrated circuit package including die 130 mounted on substrate 120. It will be understood that the dimensions of the components of system 102 are not necessarily to scale. Furthermore, the components are illustrated to show specific relationships described, and they do not necessarily represent a real-world implementation of the components. Certain components may be exaggerated or emphasized in size or placement for purposes of illustrating features described.

Substrate 120 provides a package substrate, where the package 110 is defined by substrate 120, die 130, and the packaging encasing the substrate and the die. Package 110 includes package pads or connectors and solder balls to represent the ability of the package to be connected within a larger system.

Package 110 includes multiple interconnections including package pad 112 and package pad 116. System 102 represents other package pads that are not specifically labeled. Package pad 112 has solder ball 114 and package pad 116 has solder ball 118, where the solder balls represent solder to connect package 110 in a larger system. In one example, package 110 represents a memory component mounted on a PCB (printed circuit board) through a BGA (ball grid array). In one example, die contact 132 represents a bump of die 130 to connect through trace 142 to package pad 112 and solder ball 114 of a BGA to connect the component.

Consider an example in which package pad 112 and package pad 116 connect to physically adjacent signal lines. Die 130 includes die contact 132, which represents a pad or contact or interconnect of die 130 to substrate 120. Substrate 120 can represent a package substrate to make die 130 available as a discrete component. In such an implementation, package 110 represents the discrete component package for die 130.

In one example, substrate 120 has two layers - a top surface layer and a bottom surface layer. The top surface layer can refer to the layer on which die 130 is mounted, and is represented in system 102 by layer 122. The bottom surface layer can refer to the layer opposite the side on which die 130 is mounted, and is represented in system 102 by layer 124.

In one example, substrate 120 includes more layers, and layer 122 and layer 124 are two layers of substrate 120, which can be top surface, bottom surface, or internal layers. The trace overlapping described herein can reduce the crosstalk and remove the need for more than two layers. Typically, a layer beyond the top and bottom layers would be adding to provide a ground plane or other interconnection layer. Substrate 120 can have such other layers. In one example, substrate 120 does not have such other layers.

Consider two signal lines in package 110 that are subject to crosstalk. Signal lines are subject to crosstalk when they have a physical proximity that, based on the intended operating frequency and power for signals transmitted on the signal lines, will generate electrical fields and magnetic fields that affect the adjacent signal line. In general, crosstalk refers to energy from one signal crossing over into the electrical field or magnetic field (or both) of the adjacent signal line, affecting the signal energy of the adjacent signal line. Crosstalk can have an electrical component caused by the electrical field, resulting in a capacitive crosstalk component. Crosstalk can have a magnetic component caused by the magnetic field, resulting in an inductive crosstalk component.

Trace 142 represents a trace electrically connected to die contact 132. Trace 142 connects die contact 132 to package pad 112. Trace 152 represents an adjacent trace, which would be connected to a die contact not visible from the perspective of system 102, but illustrated in system 104 of Figure 1B. Trace 152 connects the other die contact to package pad 116. Trace 142 and trace 152 represents signal traces in system 102 that are subject to crosstalk.

Far end crosstalk (FEXT) is the difference of capacitive crosstalk and inductive crosstalk, as in equation (1):

$$(1) \quad FEXT = K * \left( \frac{C_M}{C} - \frac{L_M}{M} \right),$$

where K is a constant specific to the circuit, $C_M/C$ represents the capacitive component, and $L_M/L$ represents the inductive component. The value $C_M$ or Cm represents the mutual capacitance between the lines, and the value $L_M$ or Lm represents the mutual inductance. It can be observed from equation (1) that the far end crosstalk is minimized when the capacitive and inductive components are approximately equal to each other. When the capacitive and inductive components are approximately equal, the value in the parentheses approaches zero, eliminating FEXT.

System 102 includes pad 144 in trace 142 and pad 154 in trace 152. Pad 144 and pad 154 represent additional pads in the trace routing. Rather than being pads that connect to die 130, or are package pad 112, or pads for through hole vias through substrate 120, pad 144 and pad 154 are pads in the signal traces that increase the mutual capacitance. Pad 144 is located over (overlapping) and faces pad 154, which increases the mutual capacitance (Cm), resulting in an increase in the capacitive crosstalk term (Cm/C).

Pad 144 is in layer 122 (a first layer of substrate 120) and pad 154 is in layer 124 (a second layer of substrate 120). When layer 122 and layer 124 are sufficiently close to each other, the overlapping pads have high mutual capacitance, which increases the Cm/C component. In a package that has higher inductive crosstalk, such as a high frequency memory communication, increasing Cm/C will reduce FEXT of package 110. Reducing the crosstalk of package 110 can improve memory bandwidth in a memory subsystem with high communication clock frequency. In one example, reference to high speed memory communication can refer to data transmission frequency. Thus, in one example, trace 142 and trace 152 are adjacent traces of a data bus or data signal lines, connecting data contacts of die 130 to corresponding data interconnections of package 110.

In one example, package 110 represents a high speed memory or high frequency memory component package. For example, package 110 can include substrate 120 with die 130 being a double data rate (DDR) dynamic random access memory (DRAM) device. In one example, die 130 can be a memory device compatible with a DDR5 standard (DDR version 5, JESD79-5, originally published by JEDEC in July 2020). In one example, die 130 can be a memory device compatible with an HBM standard (high bandwidth memory DRAM, JESD235A, originally published by JEDEC in November 2015). In one example, die 130 can be a DDR data buffer device. In one example, die 130 can be a data buffer device. In one example, die 130 can be a registering clock driver (RCD) device. In one example, package 110 represents a memory device (i.e., a memory die or memory chip in a discrete component package) for a DDR DRAM for an RDIMM (registered dual inline memory module).

**Figure 1B** is a side view of the system of Figure 1A. System 104 is a cutaway side view of system 102 to illustrate the how the traces overlap. It will be understood that the dimensions of the components of system 104 are not necessarily to scale. Furthermore, the components are illustrated to show specific relationships described, and they do not necessarily represent a real-world implementation of the components. Certain components may be exaggerated or emphasized in size or placement for purposes of illustrating features described.

System 104 illustrates die 130 mounted to substrate 120 through die contact 132 and through die contact 132. Die contact 132 is electrically connected to package pad 112 and solder 114 through trace 142. In one example, trace 142 includes plated through hole (PTH) 134 as a connection between two different portions of the trace. Trace 142 includes a portion in layer 122 (e.g., a first trace first portion) connected to a portion in layer 124 (e.g., a first trace second portion) through PTH 134. In one example, trace 142 includes pad 144 in layer 122. Pad 144 represents an extra pad in the trace.

Die contact 136 is electrically connected to package pad 116 and solder 118 through trace 152. In one example, trace 152 includes plated through hole (PTH) 138 as a connection between two different portions of the trace. Trace 152 includes a portion in layer 122 (e.g., a second trace first portion) connected to a portion in layer 124 (e.g., a second trace second portion) through PTH 138. In one example, trace 152 includes pad 154 in layer 124. Pad 154 represents an extra pad in the trace. Pad 144 in layer 122 and pad 154 in layer 124 are overlapping across substrate 120. Overlap 126 represents the overlap of the pads. Overlap 126 will increase the mutual capacitance of trace 152 and trace 142.

Trace 142 and trace 152 represent signal traces with first portions or portions in layer 122 that have a physical proximity to induce magnetic coupling when they transmit high frequency signal. The magnetic coupling causes mutual inductance when transmitting signals. Overlap 126 of pad 144 and pad 154 can increase mutual capacitance of the signal traces to offset the mutual inductance.

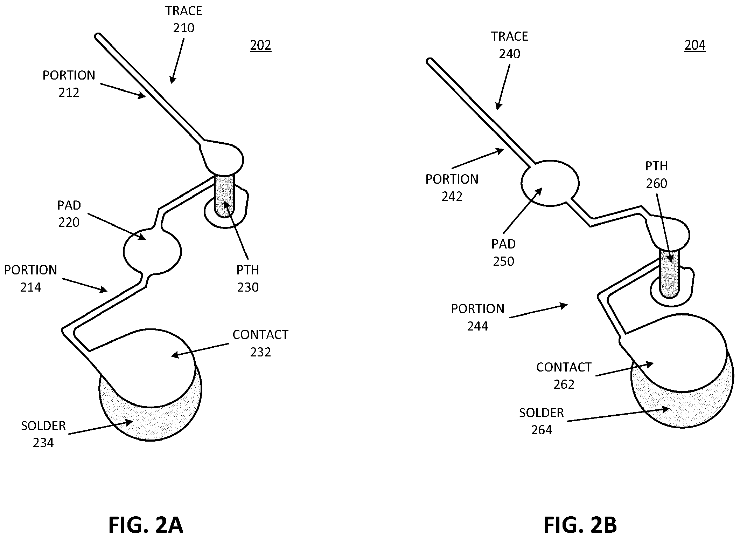

**Figure 2A** is a representation of an example of a trace with an extra pad. Diagram 202 represents an example of a signal trace with an extra pad in one layer of a substrate to overlap with a corresponding extra pad of another trace in another layer of the substrate.

Trace 210 represents a signal trace to connect to a die. Trace 210 will be in a substrate layer. Portion 212 represents a portion of trace 210 in a first layer of the substrate. PTH 230 represents a via through the substrate to make electrical connection to portion 214, which represents a portion of trace 210 in a second layer of the substrate. Portion 212 connects the die contact or die bump to PTH 230 and portion 214 connects PTH 230 to contact 232, which represents a substrate contact or interconnection or bump for the substrate and package. Solder 234 represents a solder connection to contact 232.

Pad 220 represents an extra pad in trace 210. Pad 220 is a pad in a low layer of the substrate. Pad 220 can be considered a pad in the trace after the via or after the PTH connection. The reference to "after" the via is from the perspective of the connection to the die. From the perspective of the connection to contact 232, pad 220 could be considered prior to or before PTH 230.

**Figure 2B** is a representation of an example of a trace with an extra pad to use with the trace of Figure 2A. Diagram 204 represents an example of a signal trace with an extra pad in one layer of a substrate to overlap with a corresponding extra pad of another trace in another layer of the substrate. More specifically, the extra pad of diagram 204 corresponds with the extra pad of diagram 202, to create an overlap region between the two extra pads.

Trace 240 represents a signal trace to connect to a die. Trace 240 will be in a substrate layer. Portion 242 represents a portion of trace 240 in a first layer of the substrate. PTH 260 represents a via through the substrate to make electrical connection to portion 244, which represents a portion of trace 240 in a second layer of the substrate. Portion 242 connects the die contact or die bump to PTH 260 and portion 244 connects PTH 260 to contact 262, which represents a substrate contact or interconnection or bump for the substrate and package. Solder 264 represents a solder connection to contact 262.

Pad 250 represents an extra pad in trace 240. Pad 250 is a pad in an upper layer of the substrate. Pad 250 can be considered a pad in the trace prior to or before the via or the PTH connection. The reference to "prior to" the via is from the perspective of the connection to the die. From the perspective of the connection to contact 262, pad 250 could be considered after PTH 260.

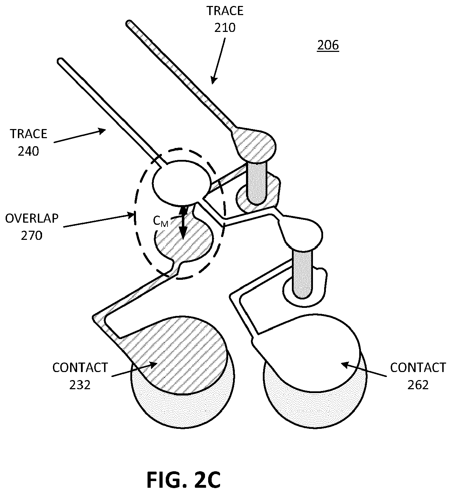

**Figure 2C** is a representation of an example of the traces of Figure 2A and Figure 2B. Diagram 206 overlays trace 210 of diagram 202 with trace 240 of diagram 204. When the traces are overlaid, the upper portions are adjacent in the upper layer of the substrate. Trace 210 extends from a die contact to substrate contact 232. Extra pad 220 of trace 210 is in the lower layer of the substrate, between the via and contact 232. Trace 240 extends from a die contact to substrate contact 262. Extra pad 250 of trace 240 is in the upper layer of the substrate, between the contact to the die and the via. Overlap 270 represents the overlap of pad 250 and pad 220. The overlap increases Cm.

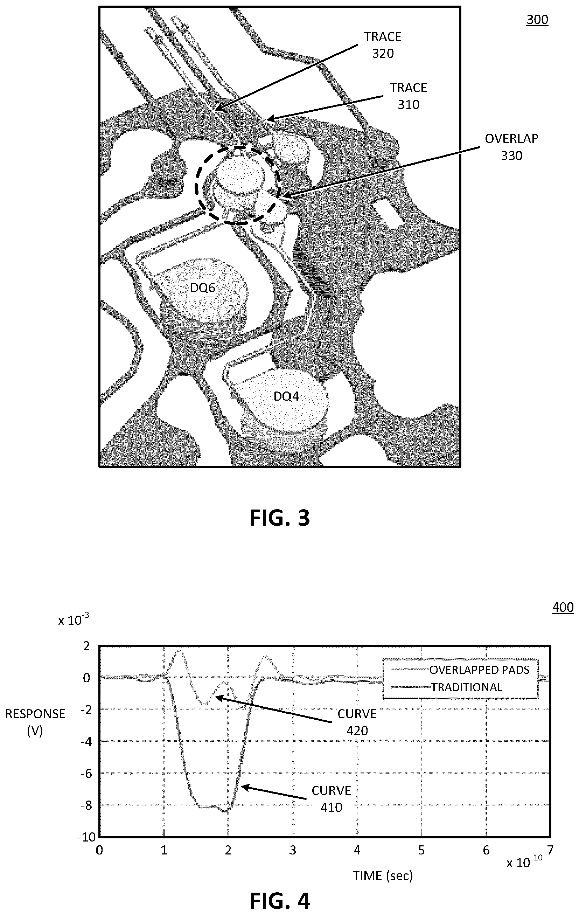

**Figure 3** is a representation of a trace layout. Diagram 300 represents a portion of a substrate layout for a DDR5 DRAM package design. Specifically, diagram 300 illustrates overlapping pads for DQ6 (data line 6) and DQ4 (data line 4).

In a traditional design, the signal lines are essentially the same as diagram 300, but without overlapping pads. Trace 310 represents a trace for DQ6. Trace 320 represents a trace for DQ4. Overlap 330 represents the overlap region of the substrate for the pad of trace 310 and the pad of trace 320. With an additional pad on each DQ signal, with pads that face each other, the layout design of diagram 300 can reduce the FEXT for the DRAM package.

**Figure 4** is a representation of voltage response versus time for different trace layouts. Diagram 400 represents a time domain FEXT comparison for overlapped pads versus a traditional layout that has only the signal traces without overlapped pads.

Curve 410 represents the voltage response versus time for a signal trace that is subject to crosstalk with an adjacent signal trace. As seen in diagram 400, from approximately a time of 1.5 to $2 \times 10^{-10}$ seconds, the signal line exhibits approximately a -8 mV pulse. Curve 420 represents the voltage response versus time for a signal trace having an overlapping pad with the signal trace that causes the crosstalk. As seen in curve 420, there is a small voltage response wobble starting at approximately $1 \times 10^{-10}$ seconds, lasting until approximately $3 \times 10^{-10}$ seconds. It can be observed that the voltage wobble is limited to approximately +/- 2 mV. There is a significant improvement in the time domain response. While not specifically shown, the same design can result in approximately a 15 dB improvement (reduction) in the frequency domain for FEXT @4 GHz.

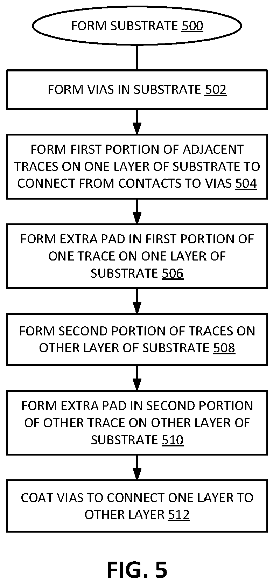

**Figure 5** is a flow diagram of an example of a process for creating a substrate having traces with overlapping pads. Process 500 represents an example of forming a package substrate with overlapping pads. It will be understood that the operations of process 500 are not necessarily presented in the order they would be performed to create the substrate.

In one example, the processing includes forming vias in the substrate, at 502. The vias can serve as connections for traces that connect different layers. In one example, the processing forms a first portion of adjacent traces on one layer of the substrate to connect from contacts to the vias or openings for the vias, at 504. The contacts can be contact to connect to a component die that will be enclosed in the package.

In one example, the processing forms an extra pad in the first portion of one of the pair of traces on one layer of the substrate, at 506. Two traces can be a pair of traces with respect to their tendency for crosstalk. The processing can form a second portion of the traces on another layer of the substrate, at 508.

In one example, the processing forms an extra pad in the second portion of the other trace of the other layer of the substrate, at 510. Thus, both traces for the adjacent signal lines will have an extra pad, one on one side of the substrate, and the other on the other side of the substrate, where the two pads face each other. The processing can coat the vias to connect one layer to the other layer, and more specifically, to connect first and second portions of the traces to each other through the substrate, at 512.

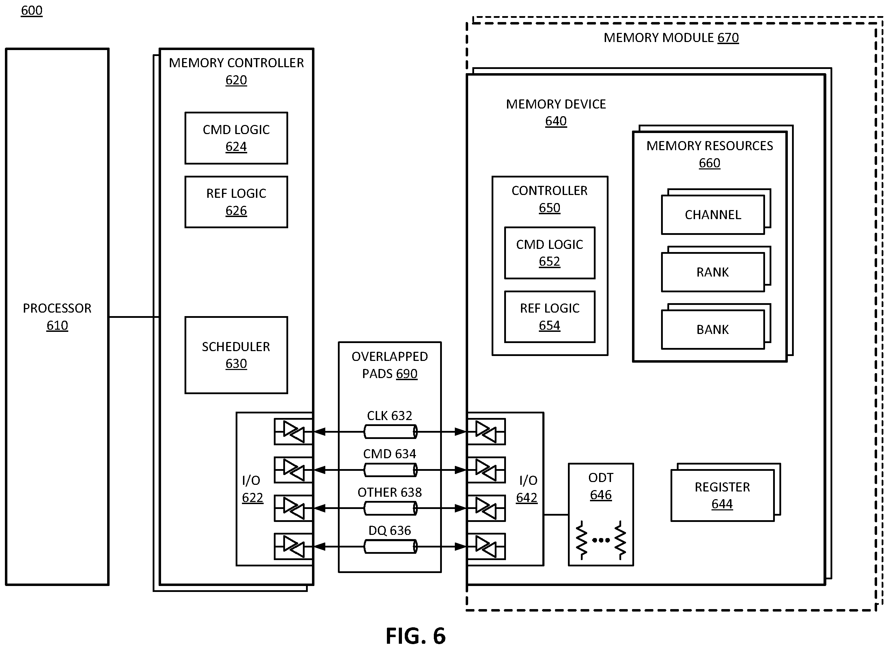

**Figure 6** is a block diagram of an example of a memory subsystem in which trace routing with overlapping pads can be implemented. System 600 includes a processor and elements of a memory subsystem in a computing device. System 600 represents a system in accordance with an example of system 102.

In one example, system 600 includes a trace layout architecture to interconnect one or more items of memory device 640 or memory module 670 with overlapped pads 690. Overlapped pads 690 can be in accordance with any example herein. In one example, overlapped pads 690 apply just to DQ 636. In one example, overlapped pads 690 are applied to other signal lines of the interface to memory device 640 or other memory component of system 600.

Processor 610 represents a processing unit of a computing platform that may execute an operating system (OS) and applications, which can collectively be referred to as the host or the user of the memory. The OS and applications execute operations that result in memory accesses. Processor 610 can include one or more separate processors. Each separate processor can include a single processing unit, a multicore processing unit, or a combination. The processing unit can be a primary processor such as a CPU (central processing unit), a peripheral processor such as a GPU (graphics processing unit), or a combination. Memory accesses may also be initiated by devices such as a network controller or hard disk controller. Such devices can be integrated with the processor in some systems or attached to the processer via a bus (e.g., PCI express), or a combination. System 600 can be implemented as an SOC (system on a chip), or be implemented with standalone components.

Reference to memory devices can apply to different memory types. Memory devices often refers to volatile memory technologies. Volatile memory is memory whose state (and therefore the data stored on it) is indeterminate if power is interrupted to the device. Nonvolatile memory refers to memory whose state is determinate even if power is interrupted to the device. Dynamic volatile memory requires refreshing the data stored in the device to maintain state. One example of dynamic volatile memory includes DRAM (dynamic random-access memory), or some variant such as synchronous DRAM (SDRAM). A memory subsystem as described herein may be compatible with a number of memory technologies, such as DDR4 (double data rate version 4, JESD79-4, originally published in September 2012 by JEDEC (Joint Electron Device Engineering Council, now the JEDEC Solid State Technology Association), LPDDR4 (low power DDR version 4, JESD209-4, originally published by JEDEC in August 2014), WIO2 (Wide I/O 2 (WideIO2), JESD229-2, originally published by JEDEC in August 2014), HBM (high bandwidth memory DRAM, JESD235A, originally published by JEDEC in November 2015), DDR5 (DDR version 5, JESD79-5, originally published by JEDEC in July 2020), LPDDR5 (LPDDR version 5, JESD209-5, originally published by JEDEC in February 2019), HBM2 ((HBM version 2), currently in discussion by JEDEC), or others or combinations of memory technologies, and technologies based on derivatives or extensions of such specifications.

Memory controller 620 represents one or more memory controller circuits or devices for system 600. Memory controller 620 represents control logic that generates memory access commands in response to the execution of operations by processor 610. Memory controller 620 accesses one or more memory devices 640. Memory devices 640 can be DRAM devices in accordance with any referred to above. In one example, memory devices 640 are organized and managed as different channels, where each channel couples to buses and signal lines that couple to multiple memory devices in parallel. Each channel is independently operable. Thus, each channel is independently accessed and controlled, and the timing, data transfer, command and address exchanges, and other operations are separate for each channel. Coupling can refer to an electrical coupling, communicative coupling, physical coupling, or a combination of these. Physical coupling can include direct contact. Electrical coupling includes an interface or interconnection that allows electrical flow between components, or allows signaling between components, or both. Communicative coupling includes connections, including wired or wireless, that enable components to exchange data.

In one example, settings for each channel are controlled by separate mode registers or other register settings. In one example, each memory controller 620 manages a separate memory channel, although system 600 can be configured to have multiple channels managed by a single controller, or to have multiple controllers on a single channel. In one example, memory controller 620 is part of host processor 610, such as logic implemented on the same die or implemented in the same package space as the processor.

Memory controller 620 includes I/O interface logic 622 to couple to a memory bus, such as a memory channel as referred to above. I/O interface logic 622 (as well as I/O interface logic 642 of memory device 640) can include pins, pads, connectors, signal lines, traces, or wires, or other hardware to connect the devices, or a combination of these. I/O interface logic 622 can include a hardware interface. As illustrated, I/O interface logic 622 includes at least drivers/transceivers for signal lines. Commonly, wires within an integrated circuit interface couple with a pad, pin, or connector to interface signal lines or traces or other wires between devices. I/O interface logic 622 can include drivers, receivers, transceivers, or termination, or other circuitry or combinations of circuitry to exchange signals on the signal lines between the devices. The exchange of signals includes at least one of transmit or receive. While shown as coupling I/O 622 from memory controller 620 to I/O 642 of memory device 640, it will be understood that in an implementation of system 600 where groups of memory devices 640 are accessed in parallel, multiple memory devices can include I/O interfaces to the same interface of memory controller 620. In an implementation of system 600 including one or more memory modules 670, I/O 642 can include interface hardware of the memory module in addition to interface hardware on the memory device itself. Other memory controllers 620 will include separate interfaces to other memory devices 640.

The bus between memory controller 620 and memory devices 640 can be implemented as multiple signal lines coupling memory controller 620 to memory devices 640. The bus may typically include at least clock (CLK) 632, command/address (CMD) 634, and write data (DQ) and read data (DQ) 636, and zero or more other signal lines 638. In one example, a bus or connection between memory controller 620 and memory can be referred to as a memory bus. In one example, the memory bus is a multi-drop bus. The signal lines for CMD can be referred to as a "C/A bus" (or ADD/CMD bus, or some other designation indicating the transfer of commands (C or CMD) and address (A or ADD) information) and the signal lines for write and read DQ can be referred to as a "data bus." In one example, independent channels have different clock signals, C/A buses, data buses, and other signal lines. Thus, system 600 can be considered to have multiple "buses," in the sense that an independent interface path can be considered a separate bus. It will be understood that in addition to the lines explicitly shown, a bus can include at least one of strobe signaling lines, alert lines, auxiliary lines, or other signal lines, or a combination. It will also be understood that serial bus technologies can be used for the connection between memory controller 620 and memory devices 640. An example of a serial bus technology is 8B10B encoding and transmission of high-speed data with embedded clock over a single differential pair of signals in each direction. In one example, CMD 634 represents signal lines shared in parallel with multiple memory devices. In one example, multiple memory devices share encoding command signal lines of CMD 634, and each has a separate chip select (CS_n) signal line to select individual memory devices.

It will be understood that in the example of system 600, the bus between memory controller 620 and memory devices 640 includes a subsidiary command bus CMD 634 and a subsidiary bus to carry the write and read data, DQ 636. In one example, the data bus can include bidirectional lines for read data and for write/command data. In another example, the subsidiary bus DQ 636 can include unidirectional write signal lines for write and data from the host to memory, and can include unidirectional lines for read data from the memory to the host. In accordance with the chosen memory technology and system design, other signals 638 may accompany a bus or sub bus, such as strobe lines DQS. Based on design of system 600, or implementation if a design supports multiple implementations, the data bus can have more or less bandwidth per memory device 640. For example, the data bus can support memory devices that have either a x4 interface, a x8 interface, a ×16 interface, or other interface. The convention "xW," where W is an integer that refers to an interface size or width of the interface of memory device 640, which represents a number of signal lines to exchange data with memory controller 620. The interface size of the memory devices is a controlling factor on how many memory devices can be used concurrently per channel in system 600 or coupled in parallel to the same signal lines. In one example, high bandwidth memory devices, wide interface devices, or stacked memory configurations, or combinations, can enable wider interfaces, such as a ×128 interface, a x256 interface, a x512 interface, a ×1024 interface, or other data bus interface width.

In one example, memory devices 640 and memory controller 620 exchange data over the data bus in a burst, or a sequence of consecutive data transfers. The burst corresponds to a number of transfer cycles, which is related to a bus frequency. In one example, the transfer cycle can be a whole clock cycle for transfers occurring on a same clock or strobe signal edge (e.g., on the rising edge). In one example, every clock cycle, referring to a cycle of the system clock, is separated into multiple unit intervals (UIs), where each UI is a transfer cycle. For example, double data rate transfers trigger on both edges of the clock signal (e.g., rising and falling). A burst can last for a configured number of UIs, which can be a configuration stored in a register, or triggered on the fly. For example, a sequence of eight consecutive transfer periods can be considered a burst length eight (BL8), and each memory device 640 can transfer data on each UI. Thus, a x8 memory device operating on BL8 can transfer 64 bits of data (8 data signal lines times 8 data bits transferred per line over the burst). It will be understood that this simple example is merely an illustration and is not limiting.

Memory devices 640 represent memory resources for system 600. In one example, each memory device 640 is a separate memory die. In one example, each memory device 640 can interface with multiple (e.g., 2) channels per device or die. Each memory device 640 includes I/O interface logic 642, which has a bandwidth determined by the implementation of the device (e.g., ×16 or x8 or some other interface bandwidth). I/O interface logic 642 enables the memory devices to interface with memory controller 620. I/O interface logic 642 can include a hardware interface, and can be in accordance with I/O 622 of memory controller, but at the memory device end. In one example, multiple memory devices 640 are connected in parallel to the same command and data buses. In another example, multiple memory devices 640 are connected in parallel to the same command bus, and are connected to different data buses. For example, system 600 can be configured with multiple memory devices 640 coupled in parallel, with each memory device responding to a command, and accessing memory resources 660 internal to each. For a Write operation, an individual memory device 640 can write a portion of the overall data word, and for a Read operation, an individual memory device 640 can fetch a portion of the overall data word. The remaining bits of the word will be provided or received by other memory devices in parallel.

In one example, memory devices 640 are disposed directly on a motherboard or host system platform (e.g., a PCB (printed circuit board) on which processor 610 is disposed) of a computing device. In one example, memory devices 640 can be organized into memory modules 670. In one example, memory modules 670 represent dual inline memory modules (DIMMs). In one example, memory modules 670 represent other organization of multiple memory devices to share at least a portion of access or control circuitry, which can be a separate circuit, a separate device, or a separate board from the host system platform. Memory modules 670 can include multiple memory devices 640, and the memory modules can include support for multiple separate channels to the included memory devices disposed on them. In another example, memory devices 640 may be incorporated into the same package as memory controller 620, such as by techniques such as multi-chip-module (MCM), package-on-package, through-silicon via (TSV), or other techniques or combinations. Similarly, in one example, multiple memory devices 640 may be incorporated into memory modules 670, which themselves may be incorporated into the same package as memory controller 620. It will be appreciated that for these and other implementations, memory controller 620 may be part of host processor 610.

Memory devices 640 each include one or more memory arrays 660. Memory array 660 represents addressable memory locations or storage locations for data. Typically, memory array 660 is managed as rows of data, accessed via wordline (rows) and bitline (individual bits within a row) control. Memory array 660 can be organized as separate channels, ranks, and banks of memory. Channels may refer to independent control paths to storage locations within memory devices 640. Ranks may refer to common locations across multiple memory devices (e.g., same row addresses within different devices) in parallel. Banks may refer to sub-arrays of memory locations within a memory device 640. In one example, banks of memory are divided into sub-banks with at least a portion of shared circuitry (e.g., drivers, signal lines, control logic) for the sub-banks, allowing separate addressing and access. It will be understood that channels, ranks, banks, sub-banks, bank groups, or other organizations of the memory locations, and combinations of the organizations, can overlap in their application to physical resources. For example, the same physical memory locations can be accessed over a specific channel as a specific bank, which can also belong to a rank. Thus, the organization of memory resources will be understood in an inclusive, rather than exclusive, manner.

In one example, memory devices 640 include one or more registers 644. Register 644 represents one or more storage devices or storage locations that provide configuration or settings for the operation of the memory device. In one example, register 644 can provide a storage location for memory device 640 to store data for access by memory controller 620 as part of a control or management operation. In one example, register 644 includes one or more Mode Registers. In one example, register 644 includes one or more multipurpose registers. The configuration of locations within register 644 can configure memory device 640 to operate in different "modes," where command information can trigger different operations within memory device 640 based on the mode. Additionally or in the alternative, different modes can also trigger different operation from address information or other signal lines depending on the mode. Settings of register 644 can indicate configuration for I/O settings (e.g., timing, termination or ODT (on-die termination) 646, driver configuration, or other I/O settings).

In one example, memory device 640 includes ODT 646 as part of the interface hardware associated with I/O 642. ODT 646 can be configured as mentioned above, and provide settings for impedance to be applied to the interface to specified signal lines. In one example, ODT 646 is applied to DQ signal lines. In one example, ODT 646 is applied to command signal lines. In one example, ODT 646 is applied to address signal lines. In one example, ODT 646 can be applied to any combination of the preceding. The ODT settings can be changed based on whether a memory device is a selected target of an access operation or a non-target device. ODT 646 settings can affect the timing and reflections of signaling on the terminated lines. Careful control over ODT 646 can enable higher-speed operation with improved matching of applied impedance and loading. ODT 646 can be applied to specific signal lines of I/O interface 642, 622 (for example, ODT for DQ lines or ODT for CA lines), and is not necessarily applied to all signal lines.

Memory device 640 includes controller 650, which represents control logic within the memory device to control internal operations within the memory device. For example, controller 650 decodes commands sent by memory controller 620 and generates internal operations to execute or satisfy the commands. Controller 650 can be referred to as an internal controller, and is separate from memory controller 620 of the host. Controller 650 can determine what mode is selected based on register 644, and configure the internal execution of operations for access to memory resources 660 or other operations based on the selected mode. Controller 650 generates control signals to control the routing of bits within memory device 640 to provide a proper interface for the selected mode and direct a command to the proper memory locations or addresses. Controller 650 includes command logic 652, which can decode command encoding received on command and address signal lines. Thus, command logic 652 can be or include a command decoder. With command logic 652, memory device can identify commands and generate internal operations to execute requested commands.

Referring again to memory controller 620, memory controller 620 includes command (CMD) logic 624, which represents logic or circuitry to generate commands to send to memory devices 640. The generation of the commands can refer to the command prior to scheduling, or the preparation of queued commands ready to be sent. Generally, the signaling in memory subsystems includes address information within or accompanying the command to indicate or select one or more memory locations where the memory devices should execute the command. In response to scheduling of transactions for memory device 640, memory controller 620 can issue commands via I/O 622 to cause memory device 640 to execute the commands. In one example, controller 650 of memory device 640 receives and decodes command and address information received via I/O 642 from memory controller 620. Based on the received command and address information, controller 650 can control the timing of operations of the logic and circuitry within memory device 640 to execute the commands. Controller 650 is responsible for compliance with standards or specifications within memory device 640, such as timing and signaling requirements. Memory controller 620 can implement compliance with standards or specifications by access scheduling and control.

Memory controller 620 includes scheduler 630, which represents logic or circuitry to generate and order transactions to send to memory device 640. From one perspective, the primary function of memory controller 620 could be said to schedule memory access and other transactions to memory device 640. Such scheduling can include generating the transactions themselves to implement the requests for data by processor 610 and to maintain integrity of the data (e.g., such as with commands related to refresh). Transactions can include one or more commands, and result in the transfer of commands or data or both over one or multiple timing cycles such as clock cycles or unit intervals. Transactions can be for access such as read or write or related commands or a combination, and other transactions can include memory management commands for configuration, settings, data integrity, or other commands or a combination.

Memory controller 620 typically includes logic such as scheduler 630 to allow selection and ordering of transactions to improve performance of system 600.

Thus, memory controller 620 can select which of the outstanding transactions should be sent to memory device 640 in which order, which is typically achieved with logic much more complex that a simple first-in first-out algorithm. Memory controller 620 manages the transmission of the transactions to memory device 640, and manages the timing associated with the transaction. In one example, transactions have deterministic timing, which can be managed by memory controller 620 and used in determining how to schedule the transactions with scheduler 630.

In one example, memory controller 620 includes refresh (REF) logic 626. Refresh logic 626 can be used for memory resources that are volatile and need to be refreshed to retain a deterministic state. In one example, refresh logic 626 indicates a location for refresh, and a type of refresh to perform. Refresh logic 626 can trigger self-refresh within memory device 640, or execute external refreshes which can be referred to as auto refresh commands) by sending refresh commands, or a combination. In one example, controller 650 within memory device 640 includes refresh logic 654 to apply refresh within memory device 640. In one example, refresh logic 654 generates internal operations to perform refresh in accordance with an external refresh received from memory controller 620. Refresh logic 654 can determine if a refresh is directed to memory device 640, and what memory resources 660 to refresh in response to the command.

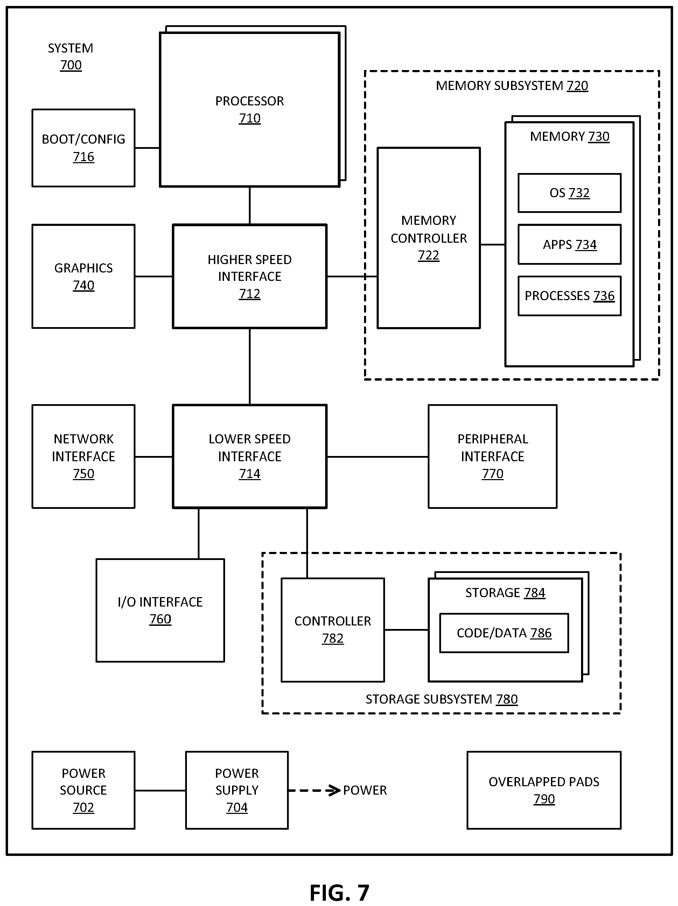

**Figure** 7 is a block diagram of an example of a computing system in which trace routing with overlapping pads can be implemented. System 700 represents a computing device in accordance with any example herein, and can be a laptop computer, a desktop computer, a tablet computer, a server, a gaming or entertainment control system, embedded computing device, or other electronic device.

In one example, system 700 includes a trace layout architecture to interconnect one or more components of the system with overlapped pads 790. Overlapped pads 790 can be in accordance with any example herein. In one example, overlapped pads 790 can apply to one or more components of memory subsystem 720, one or more interface components of interface 712 or interface 714, or other component in system 700.

System 700 includes processor 710 can include any type of microprocessor, central processing unit (CPU), graphics processing unit (GPU), processing core, or other processing hardware, or a combination, to provide processing or execution of instructions for system 700. Processor 710 can be a host processor device. Processor 710 controls the overall operation of system 700, and can be or include, one or more programmable general-purpose or special-purpose microprocessors, digital signal processors (DSPs), programmable controllers, application specific integrated circuits (ASICs), programmable logic devices (PLDs), or a combination of such devices.

System 700 includes boot/config 716, which represents storage to store boot code (e.g., basic input/output system (BIOS)), configuration settings, security hardware (e.g., trusted platform module (TPM)), or other system level hardware that operates outside of a host OS. Boot/config 716 can include a nonvolatile storage device, such as read-only memory (ROM), flash memory, or other memory devices.

In one example, system 700 includes interface 712 coupled to processor 710, which can represent a higher speed interface or a high throughput interface for system components that need higher bandwidth connections, such as memory subsystem 720 or graphics interface components 740. Interface 712 represents an interface circuit, which can be a standalone component or integrated onto a processor die. Interface 712 can be integrated as a circuit onto the processor die or integrated as a component on a system on a chip. Where present, graphics interface 740 interfaces to graphics components for providing a visual display to a user of system 700. Graphics interface 740 can be a standalone component or integrated onto the processor die or system on a chip. In one example, graphics interface 740 can drive a high definition (HD) display or ultra high definition (UHD) display that provides an output to a user. In one example, the display can include a touchscreen display. In one example, graphics interface 740 generates a display based on data stored in memory 730 or based on operations executed by processor 710 or both.

Memory subsystem 720 represents the main memory of system 700, and provides storage for code to be executed by processor 710, or data values to be used in executing a routine. Memory subsystem 720 can include one or more varieties of random-access memory (RAM) such as DRAM, 3DXP (three-dimensional crosspoint), or other memory devices, or a combination of such devices. Memory 730 stores and hosts, among other things, operating system (OS) 732 to provide a software platform for execution of instructions in system 700. Additionally, applications 734 can execute on the software platform of OS 732 from memory 730. Applications 734 represent programs that have their own operational logic to perform execution of one or more functions. Processes 736 represent agents or routines that provide auxiliary functions to OS 732 or one or more applications 734 or a combination. OS 732, applications 734, and processes 736 provide software logic to provide functions for system 700. In one example, memory subsystem 720 includes memory controller 722, which is a memory controller to generate and issue commands to memory 730. It will be understood that memory controller 722 could be a physical part of processor 710 or a physical part of interface 712. For example, memory controller 722 can be an integrated memory controller, integrated onto a circuit with processor 710, such as integrated onto the processor die or a system on a chip.

While not specifically illustrated, it will be understood that system 700 can include one or more buses or bus systems between devices, such as a memory bus, a graphics bus, interface buses, or others. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a Peripheral Component Interconnect (PCI) bus, a HyperTransport or industry standard architecture (ISA) bus, a small computer system interface (SCSI) bus, a universal serial bus (USB), or other bus, or a combination.

In one example, system 700 includes interface 714, which can be coupled to interface 712. Interface 714 can be a lower speed interface than interface 712. In one example, interface 714 represents an interface circuit, which can include standalone components and integrated circuitry. In one example, multiple user interface components or peripheral components, or both, couple to interface 714. Network interface 750 provides system 700 the ability to communicate with remote devices (e.g., servers or other computing devices) over one or more networks. Network interface 750 can include an Ethernet adapter, wireless interconnection components, cellular network interconnection components, USB (universal serial bus), or other wired or wireless standards-based or proprietary interfaces. Network interface 750 can exchange data with a remote device, which can include sending data stored in memory or receiving data to be stored in memory.

In one example, system 700 includes one or more input/output (I/O) interface(s) 760. I/O interface 760 can include one or more interface components through which a user interacts with system 700 (e.g., audio, alphanumeric, tactile/touch, or other interfacing). Peripheral interface 770 can include any hardware interface not specifically mentioned above. Peripherals refer generally to devices that connect dependently to system 700. A dependent connection is one where system 700 provides the software platform or hardware platform or both on which operation executes, and with which a user interacts.

In one example, system 700 includes storage subsystem 780 to store data in a nonvolatile manner. In one example, in certain system implementations, at least certain components of storage 780 can overlap with components of memory subsystem 720. Storage subsystem 780 includes storage device(s) 784, which can be or include any conventional medium for storing large amounts of data in a nonvolatile manner, such as one or more magnetic, solid state, NAND, 3DXP, or optical based disks, or a combination. Storage 784 holds code or instructions and data 786 in a persistent state (i.e., the value is retained despite interruption of power to system 700). Storage 784 can be generically considered to be a "memory," although memory 730 is typically the executing or operating memory to provide instructions to processor 710. Whereas storage 784 is nonvolatile, memory 730 can include volatile memory (i.e., the value or state of the data is indeterminate if power is interrupted to system 700). In one example, storage subsystem 780 includes controller 782 to interface with storage 784. In one example controller 782 is a physical part of interface 714 or processor 710, or can include circuits or logic in both processor 710 and interface 714.

Power source 702 provides power to the components of system 700. More specifically, power source 702 typically interfaces to one or multiple power supplies 704 in system 700 to provide power to the components of system 700. In one example, power supply 704 includes an AC to DC (alternating current to direct current) adapter to plug into a wall outlet. Such AC power can be renewable energy (e.g., solar power) power source 702. In one example, power source 702 includes a DC power source, such as an external AC to DC converter. In one example, power source 702 or power supply 704 includes wireless charging hardware to charge via proximity to a charging field. In one example, power source 702 can include an internal battery or fuel cell source.

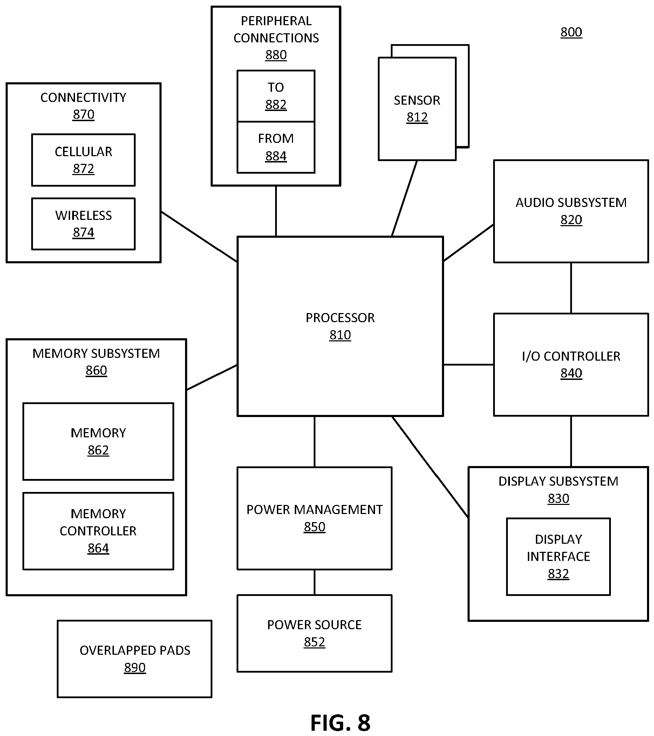

**Figure 8** is a block diagram of an example of a mobile device in which trace routing with overlapping pads can be implemented. System 800 represents a mobile computing device, such as a computing tablet, a mobile phone or smartphone, wearable computing device, or other mobile device, or an embedded computing device. It will be understood that certain of the components are shown generally, and not all components of such a device are shown in system 800.

In one example, system 800 includes a trace layout architecture to interconnect one or more components of the system with overlapped pads 890. Overlapped pads 890 can be in accordance with any example herein. In one example, overlapped pads 890 can apply to one or more components of memory subsystem 860 or other component in system 800.

System 800 includes processor 810, which performs the primary processing operations of system 800. Processor 810 can be a host processor device. Processor 810 can include one or more physical devices, such as microprocessors, application processors, microcontrollers, programmable logic devices, or other processing means. The processing operations performed by processor 810 include the execution of an operating platform or operating system on which applications and device functions are executed. The processing operations include operations related to I/O (input/output) with a human user or with other devices, operations related to power management, operations related to connecting system 800 to another device, or a combination. The processing operations can also include operations related to audio I/O, display I/O, or other interfacing, or a combination. Processor 810 can execute data stored in memory. Processor 810 can write or edit data stored in memory.

In one example, system 800 includes one or more sensors 812. Sensors 812 represent embedded sensors or interfaces to external sensors, or a combination. Sensors 812 enable system 800 to monitor or detect one or more conditions of an environment or a device in which system 800 is implemented. Sensors 812 can include environmental sensors (such as temperature sensors, motion detectors, light detectors, cameras, chemical sensors (e.g., carbon monoxide, carbon dioxide, or other chemical sensors)), pressure sensors, accelerometers, gyroscopes, medical or physiology sensors (e.g., biosensors, heart rate monitors, or other sensors to detect physiological attributes), or other sensors, or a combination. Sensors 812 can also include sensors for biometric systems such as fingerprint recognition systems, face detection or recognition systems, or other systems that detect or recognize user features. Sensors 812 should be understood broadly, and not limiting on the many different types of sensors that could be implemented with system 800. In one example, one or more sensors 812 couples to processor 810 via a frontend circuit integrated with processor 810. In one example, one or more sensors 812 couples to processor 810 via another component of system 800.

In one example, system 800 includes audio subsystem 820, which represents hardware (e.g., audio hardware and audio circuits) and software (e.g., drivers, codecs) components associated with providing audio functions to the computing device. Audio functions can include speaker or headphone output, as well as microphone input. Devices for such functions can be integrated into system 800, or connected to system 800. In one example, a user interacts with system 800 by providing audio commands that are received and processed by processor 810.

Display subsystem 830 represents hardware (e.g., display devices) and software components (e.g., drivers) that provide a visual display for presentation to a user. In one example, the display includes tactile components or touchscreen elements for a user to interact with the computing device. Display subsystem 830 includes display interface 832, which includes the particular screen or hardware device used to provide a display to a user. In one example, display interface 832 includes logic separate from processor 810 (such as a graphics processor) to perform at least some processing related to the display. In one example, display subsystem 830 includes a touchscreen device that provides both output and input to a user. In one example, display subsystem 830 includes a high definition (HD) or ultra-high definition (UHD) display that provides an output to a user. In one example, display subsystem includes or drives a touchscreen display. In one example, display subsystem 830 generates display information based on data stored in memory or based on operations executed by processor 810 or both.

I/O controller 840 represents hardware devices and software components related to interaction with a user. I/O controller 840 can operate to manage hardware that is part of audio subsystem 820, or display subsystem 830, or both. Additionally, I/O controller 840 illustrates a connection point for additional devices that connect to system 800 through which a user might interact with the system. For example, devices that can be attached to system 800 might include microphone devices, speaker or stereo systems, video systems or other display device, keyboard or keypad devices, buttons/switches, or other I/O devices for use with specific applications such as card readers or other devices.

As mentioned above, I/O controller 840 can interact with audio subsystem 820 or display subsystem 830 or both. For example, input through a microphone or other audio device can provide input or commands for one or more applications or functions of system 800. Additionally, audio output can be provided instead of or in addition to display output. In another example, if display subsystem includes a touchscreen, the display device also acts as an input device, which can be at least partially managed by I/O controller 840. There can also be additional buttons or switches on system 800 to provide I/O functions managed by I/O controller 840.

In one example, I/O controller 840 manages devices such as accelerometers, cameras, light sensors or other environmental sensors, gyroscopes, global positioning system (GPS), or other hardware that can be included in system 800, or sensors 812. The input can be part of direct user interaction, as well as providing environmental input to the system to influence its operations (such as filtering for noise, adjusting displays for brightness detection, applying a flash for a camera, or other features).

In one example, system 800 includes power management 850 that manages battery power usage, charging of the battery, and features related to power saving operation. Power management 850 manages power from power source 852, which provides power to the components of system 800. In one example, power source 852 includes an AC to DC (alternating current to direct current) adapter to plug into a wall outlet. Such AC power can be renewable energy (e.g., solar power, motion based power). In one example, power source 852 includes only DC power, which can be provided by a DC power source, such as an external AC to DC converter. In one example, power source 852 includes wireless charging hardware to charge via proximity to a charging field. In one example, power source 852 can include an internal battery or fuel cell source.

Memory subsystem 860 includes memory device(s) 862 for storing information in system 800. Memory subsystem 860 can include nonvolatile (state does not change if power to the memory device is interrupted) or volatile (state is indeterminate if power to the memory device is interrupted) memory devices, or a combination. Memory 860 can store application data, user data, music, photos, documents, or other data, as well as system data (whether long-term or temporary) related to the execution of the applications and functions of system 800. In one example, memory subsystem 860 includes memory controller 864 (which could also be considered part of the control of system 800, and could potentially be considered part of processor 810). Memory controller 864 includes a scheduler to generate and issue commands to control access to memory device 862.

Connectivity 870 includes hardware devices (e.g., wireless or wired connectors and communication hardware, or a combination of wired and wireless hardware) and software components (e.g., drivers, protocol stacks) to enable system 800 to communicate with external devices. The external device could be separate devices, such as other computing devices, wireless access points or base stations, as well as peripherals such as headsets, printers, or other devices. In one example, system 800 exchanges data with an external device for storage in memory or for display on a display device. The exchanged data can include data to be stored in memory, or data already stored in memory, to read, write, or edit data.

Connectivity 870 can include multiple different types of connectivity. To generalize, system 800 is illustrated with cellular connectivity 872 and wireless connectivity 874. Cellular connectivity 872 refers generally to cellular network connectivity provided by wireless carriers, such as provided via GSM (global system for mobile communications) or variations or derivatives, CDMA (code division multiple access) or variations or derivatives, TDM (time division multiplexing) or variations or derivatives, LTE (long term evolution - also referred to as "4G"), 5G, or other cellular service standards. Wireless connectivity 874 refers to wireless connectivity that is not cellular, and can include personal area networks (such as Bluetooth), local area networks (such as WiFi), or wide area networks (such as WiMax), or other wireless communication, or a combination. Wireless communication refers to transfer of data through the use of modulated electromagnetic radiation through a non-solid medium. Wired communication occurs through a solid communication medium.

Peripheral connections 880 include hardware interfaces and connectors, as well as software components (e.g., drivers, protocol stacks) to make peripheral connections. It will be understood that system 800 could both be a peripheral device ("to" 882) to other computing devices, as well as have peripheral devices ("from" 884) connected to it. System 800 commonly has a "docking" connector to connect to other computing devices for purposes such as managing (e.g., downloading, uploading, changing, synchronizing) content on system 800. Additionally, a docking connector can allow system 800 to connect to certain peripherals that allow system 800 to control content output, for example, to audiovisual or other systems.

In addition to a proprietary docking connector or other proprietary connection hardware, system 800 can make peripheral connections 880 via common or standards-based connectors. Common types can include a Universal Serial Bus (USB) connector (which can include any of a number of different hardware interfaces), DisplayPort including MiniDisplayPort (MDP), High Definition Multimedia Interface (HDMI), or other type.

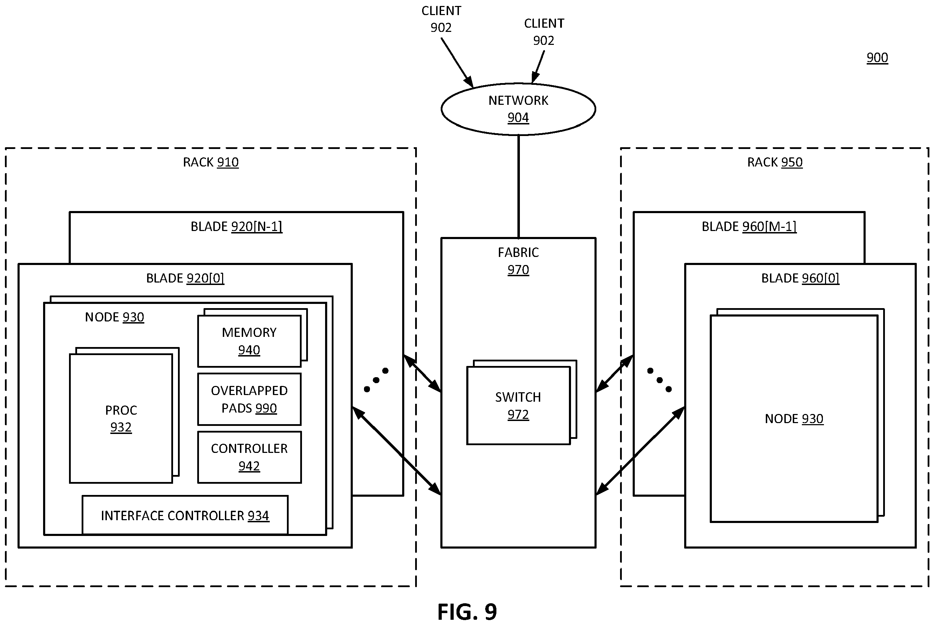

**Figure 9** is a block diagram of an example of a multi-node network in which trace routing with overlapping pads can be implemented. System 900 represents a network of nodes that can apply adaptive ECC. In one example, system 900 represents a data center. In one example, system 900 represents a server farm. In one example, system 900 represents a data cloud or a processing cloud.

Node 930 represents a system in accordance with an example of system 102. In one example, one or more components of node 930 includes a trace layout architecture to interconnect one or more components of the system with overlapped pads 990. Overlapped pads 990 can be in accordance with any example herein. In one example, overlapped pads 990 can apply to one or more components of memory 940 or other component in node 930.

One or more clients 902 make requests over network 904 to system 900. Network 904 represents one or more local networks, or wide area networks, or a combination. Clients 902 can be human or machine clients, which generate requests for the execution of operations by system 900. System 900 executes applications or data computation tasks requested by clients 902.

In one example, system 900 includes one or more racks, which represent structural and interconnect resources to house and interconnect multiple computation nodes. In one example, rack 910 includes multiple nodes 930. In one example, rack 910 hosts multiple blade components 920. Hosting refers to providing power, structural or mechanical support, and interconnection. Blades 920 can refer to computing resources on printed circuit boards (PCBs), where a PCB houses the hardware components for one or more nodes 930. In one example, blades 920 do not include a chassis or housing or other "box" other than that provided by rack 910. In one example, blades 920 include housing with exposed connector to connect into rack 910. In one example, system 900 does not include rack 910, and each blade 920 includes a chassis or housing that can stack or otherwise reside in close proximity to other blades and allow interconnection of nodes 930.

System 900 includes fabric 970, which represents one or more interconnectors for nodes 930. In one example, fabric 970 includes multiple switches 972 or routers or other hardware to route signals among nodes 930. Additionally, fabric 970 can couple system 900 to network 904 for access by clients 902. In addition to routing equipment, fabric 970 can be considered to include the cables or ports or other hardware equipment to couple nodes 930 together. In one example, fabric 970 has one or more associated protocols to manage the routing of signals through system 900. In one example, the protocol or protocols is at least partly dependent on the hardware equipment used in system 900.

As illustrated, rack 910 includes N blades 920. In one example, in addition to rack 910, system 900 includes rack 950. As illustrated, rack 950 includes M blades 960. M is not necessarily the same as N; thus, it will be understood that various different hardware equipment components could be used, and coupled together into system 900 over fabric 970. Blades 960 can be the same or similar to blades 920. Nodes 930 can be any type of node and are not necessarily all the same type of node. System 900 is not limited to being homogenous, nor is it limited to not being homogenous.

For simplicity, only the node in blade 920[0] is illustrated in detail. However, other nodes in system 900 can be the same or similar. At least some nodes 930 are computation nodes, with processor (proc) 932 and memory 940. A computation node refers to a node with processing resources (e.g., one or more processors) that executes an operating system and can receive and process one or more tasks. In one example, at least some nodes 930 are server nodes with a server as processing resources represented by processor 932 and memory 940. A storage server refers to a node with more storage resources than a computation node, and rather than having processors for the execution of tasks, a storage server includes processing resources to manage access to the storage nodes within the storage server.

In one example, node 930 includes interface controller 934, which represents logic to control access by node 930 to fabric 970. The logic can include hardware resources to interconnect to the physical interconnection hardware. The logic can include software or firmware logic to manage the interconnection. In one example, interface controller 934 is or includes a host fabric interface, which can be a fabric interface in accordance with any example described herein.

Processor 932 can include one or more separate processors. Each separate processor can include a single processing unit, a multicore processing unit, or a combination. The processing unit can be a primary processor such as a CPU (central processing unit), a peripheral processor such as a GPU (graphics processing unit), or a combination. Memory 940 can be or include memory devices and controller 942 can be a memory controller to manage access to memory 940.

In general with respect to the descriptions herein, in one example an apparatus includes: a first signal trace having a first trace first portion in a first layer of a substrate, a first trace second portion in a second layer of the substrate, and a first connection through the substrate to electrically connect the first trace first portion to the first trace second portion; and a second signal trace having a second trace first portion in the first layer of the substrate, a second trace second portion in the second layer of the substrate, and a second connection through the substrate to electrically connect the second trace first portion to the second trace second portion; wherein the first trace first portion has a first pad in the first layer of the substrate, and the second trace second portion has a second pad in the second layer of the substrate, the first pad and the second pad to overlap each other across the substrate.

In one example of the apparatus, the first connection and the second connection comprise plated through hold (PTH) connections. In accordance with any preceding example of the apparatus, in one example, the first trace first portion and the second trace first portion have a physical proximity to induce magnetic coupling to cause mutual inductance when transmitting signals. In accordance with any preceding example of the apparatus, in one example, the first pad and the second pad increase mutual capacitance to offset the mutual inductance. In accordance with any preceding example of the apparatus, in one example, the substrate comprises a component package substrate with a ball grid array (BGA), wherein the first trace and the second trace electrically connect the BGA to pads to connect to an integrated circuit die. In accordance with any preceding example of the apparatus, in one example, the first signal trace and the second signal trace comprise signal traces for a high speed memory package. In accordance with any preceding example of the apparatus, in one example, the first signal trace and the second signal trace comprise signal traces for a package with double data rate (DDR) dynamic random access memory (DRAM) devices. In accordance with any preceding example of the apparatus, in one example, the first signal trace and the second signal trace comprise signal traces for a package with a registering clock driver (RCD) device. In accordance with any preceding example of the apparatus, in one example, the first signal trace and the second signal trace comprise signal traces for a package with high bandwidth memory (HBM) devices. In accordance with any preceding example of the apparatus, in one example, the first signal trace and the second signal trace comprise signal traces from data contacts of a memory die to substrate interconnects.

In general with respect to the descriptions herein, in one example a computer system includes: a system printed circuit board (PCB); and a component package including an integrated circuit die; and a substrate having contacts to which the integrated circuit die is connected, and having a ball grid array (BGA) to electrically connect the component package to the PCB, the substrate including a first signal trace having a first trace first portion in a first layer of the substrate, a first trace second portion in a second layer of the substrate, and a first connection through the substrate to electrically connect the first trace first portion to the first trace second portion; and a second signal trace having a second trace first portion in the first layer of the substrate, a second trace second portion in the second layer of the substrate, and a second connection through the substrate to electrically connect the second trace first portion to the second trace second portion; wherein the first trace first portion has a first pad in the first layer of the substrate, and the second trace second portion has a second pad in the second layer of the substrate, the first pad and the second pad to overlap each other across the substrate.

In one example of the computer system, the first connection and the second connection comprise plated through hold (PTH) connections. In accordance with any preceding example of the computer system, in one example, the first trace first portion and the second trace first portion have a physical proximity to induce magnetic coupling to cause mutual inductance when transmitting signals. In accordance with any preceding example of the computer system, in one example, the first pad and the second pad increase mutual capacitance to offset the mutual inductance. In accordance with any preceding example of the computer system, in one example, the integrated circuit die comprises a double data rate (DDR) dynamic random access memory (DRAM) device. In accordance with any preceding example of the computer system, in one example, the integrated circuit die comprises a registering clock driver (RCD) device. In accordance with any preceding example of the computer system, in one example, the integrated circuit die comprises a double data rate (DDR) data buffer device. In accordance with any preceding example of the computer system, in one example, the integrated circuit die comprises a high bandwidth memory (HBM) device. In accordance with any preceding example of the computer system, in one example, the first signal trace and the second signal trace comprise signal traces from data contacts of a memory die to substrate interconnects. In accordance with any preceding example of the computer system, in one example, the computer system includes one or more of: a host processor communicatively coupled to the PCB; a memory controller communicatively coupled to the PCB; a display communicatively coupled to a host processor; or a network interface communicatively coupled to a host processor.

Flow diagrams as illustrated herein provide examples of sequences of various process actions. The flow diagrams can indicate operations to be executed by a software or firmware routine, as well as physical operations. A flow diagram can illustrate an example of the implementation of states of a finite state machine (FSM), which can be implemented in hardware and/or software. Although shown in a particular sequence or order, unless otherwise specified, the order of the actions can be modified. Thus, the illustrated diagrams should be understood only as examples, and the process can be performed in a different order, and some actions can be performed in parallel. Additionally, one or more actions can be omitted; thus, not all implementations will perform all actions.

To the extent various operations or functions are described herein, they can be described or defined as software code, instructions, configuration, and/or data. The content can be directly executable ("object" or "executable" form), source code, or difference code ("delta" or "patch" code). The software content of what is described herein can be provided via an article of manufacture with the content stored thereon, or via a method of operating a communication interface to send data via the communication interface. A machine readable storage medium can cause a machine to perform the functions or operations described, and includes any mechanism that stores information in a form accessible by a machine (e.g., computing device, electronic system, etc.), such as recordable/non-recordable media (e.g., read only memory (ROM), random access memory (RAM), magnetic disk storage media, optical storage media, flash memory devices, etc.). A communication interface includes any mechanism that interfaces to any of a hardwired, wireless, optical, etc., medium to communicate to another device, such as a memory bus interface, a processor bus interface, an Internet connection, a disk controller, etc. The communication interface can be configured by providing configuration parameters and/or sending signals to prepare the communication interface to provide a data signal describing the software content. The communication interface can be accessed via one or more commands or signals sent to the communication interface.

Various components described herein can be a means for performing the operations or functions described. Each component described herein includes software, hardware, or a combination of these. The components can be implemented as software modules, hardware modules, special-purpose hardware (e.g., application specific hardware, application specific integrated circuits (ASICs), digital signal processors (DSPs), etc.), embedded controllers, hardwired circuitry, etc.

Besides what is described herein, various modifications can be made to what is disclosed and implementations of the invention without departing from their scope. Therefore, the illustrations and examples herein should be construed in an illustrative, and not a restrictive sense. The scope of the invention should be measured solely by reference to the claims that follow.

**Claims**

1. An apparatus for interconnection, comprising:

  a first signal trace having a first trace first portion in a first layer of a substrate, a first trace second portion in a second layer of the substrate, and a first connection through the substrate to electrically connect the first trace first portion to the first trace second portion; and
  a second signal trace having a second trace first portion in the first layer of the substrate, a second trace second portion in the second layer of the substrate, and a second connection through the substrate to electrically connect the second trace first portion to the second trace second portion;
  wherein the first trace first portion has a first pad in the first layer of the substrate, and the second trace second portion has a second pad in the second layer of the substrate, the first pad and the second pad to overlap each other across the substrate.

2. The apparatus of claim 1, wherein the first connection and the second connection comprise plated through hold (PTH) connections.

3. The apparatus of either of claims 1 to 2, wherein the first trace first portion and the second trace first portion have a physical proximity to induce magnetic coupling to cause mutual inductance when transmitting signals.

4. The apparatus of claim 3, wherein the first pad and the second pad increase mutual capacitance to offset the mutual inductance.

5. The apparatus of any of claims 1 to 4, wherein the substrate comprises a component package substrate with a ball grid array (BGA), wherein the first trace and the second trace electrically connect the BGA to pads to connect to an integrated circuit die.

6. The apparatus of any of claims 1 to 5, wherein the first signal trace and the second signal trace comprise signal traces for a high speed memory package.

7. The apparatus of claim 6, wherein the first signal trace and the second signal trace comprise signal traces for a package with double data rate (DDR) dynamic random access memory (DRAM) devices.

8. The apparatus of claim 6, wherein the first signal trace and the second signal trace comprise signal traces for a package with a registering clock driver (RCD) device.

9. The apparatus of claim 6, wherein the first signal trace and the second signal trace comprise signal traces for a package with high bandwidth memory (HBM) devices.

10. The apparatus of claim 6, wherein the first signal trace and the second signal trace comprise signal traces from data contacts of a memory die to substrate interconnects.

11. A computer system, comprising:

a system printed circuit board (PCB); and
a component package including

an integrated circuit die; and
a substrate having contacts to which the integrated circuit die is connected, and having a ball grid array (BGA) to electrically connect the component package to the PCB, the substrate including an apparatus for interconnection in accordance with any of claims 1 to 10.

12. The computer system of claim 11, wherein the integrated circuit die comprises a double data rate (DDR) data buffer device.

13. The computer system of either of claims 11 to 12, further comprising one or more of:

a host processor communicatively coupled to the PCB;
a memory controller communicatively coupled to the PCB;
a display communicatively coupled to a host processor; or
a network interface communicatively coupled to a host processor.

DIE CONTACT
132

102

PACKAGE
110

TRACE
142

PAD
144

DIE
130

SUBSTRATE
120

PACKAGE
PAD
116

LAYER
122

LAYER
124

PACKAGE
PAD
112

SOLDER
114

TRACE
152

PAD
154

SOLDER
118

**FIG. 1A**

104

DIE CONTACT
136

DIE CONTACT
132

PACKAGE 110

PACKAGE PAD
112

PACKAGE PAD
116

DIE
130

LAYER
122

OVERLAP
126

SUBSTRATE
120

LAYER
124

PTH
138

TRACE
152

PAD
144

PAD
154

PTH
134

TRACE
142

SOLDER
114

TRACE
152

SOLDER
118

**FIG. 1B**

**FIG. 2A**

**FIG. 2B**

EP 4 210 099 A1

TRACE
210

206

TRACE
240

OVERLAP
270

$C_M$

CONTACT
232

CONTACT
262

# FIG. 2C

300

TRACE
320

TRACE
310

OVERLAP
330

DQ6

DQ4

**FIG. 3**

400

x 10⁻³

RESPONSE
(V)

CURVE
420

CURVE
410

OVERLAPPED PADS
TRADITIONAL

TIME (sec)

x 10⁻¹⁰

**FIG. 4**

FORM SUBSTRATE 500

FORM VIAS IN SUBSTRATE 502

FORM FIRST PORTION OF ADJACENT TRACES ON ONE LAYER OF SUBSTRATE TO CONNECT FROM CONTACTS TO VIAS 504

FORM EXTRA PAD IN FIRST PORTION OF ONE TRACE ON ONE LAYER OF SUBSTRATE 506

FORM SECOND PORTION OF TRACES ON OTHER LAYER OF SUBSTRATE 508

FORM EXTRA PAD IN SECOND PORTION OF OTHER TRACE ON OTHER LAYER OF SUBSTRATE 510

COAT VIAS TO CONNECT ONE LAYER TO OTHER LAYER 512

**FIG. 5**

**FIG. 6**

EP 4 210 099 A1

SYSTEM
700

PROCESSOR
710

BOOT/CONFIG
716

MEMORY SUBSYSTEM 720

MEMORY 730

OS 732

APPS 734

PROCESSES 736

MEMORY
CONTROLLER
722

GRAPHICS
740

HIGHER SPEED
INTERFACE
712

NETWORK
INTERFACE
750

LOWER SPEED
INTERFACE
714

PERIPHERAL
INTERFACE
770

I/O INTERFACE
760

CONTROLLER
782

STORAGE 784

CODE/DATA 786

STORAGE SUBSYSTEM 780

POWER
SOURCE
702

POWER
SUPPLY
704

POWER

OVERLAPPED PADS
790

FIG. 7

FIG. 8

CLIENT
902

CLIENT
902

900

NETWORK
904

RACK 910

RACK 950

BLADE 920[N-1]

BLADE 960[M-1]

FABRIC
970

BLADE 920[0]

BLADE 960[0]

NODE 930

MEMORY
940

OVERLAPPED
PADS 990

PROC
932

SWITCH
972

NODE 930

CONTROLLER
942

INTERFACE CONTROLLER 934

FIG. 9

Europäisches
Patentamt

European
Patent Office

Office européen
des brevets

# EUROPEAN SEARCH REPORT

**Application Number**

EP 22 20 9061

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2016/262260 A1 (OYAMADA SEISEI [JP] ET AL) 8 September 2016 (2016-09-08) * figures 1,2 * ----- | 1-13 | INV. H01L23/498 H01L23/66 H01L23/552 |
| A | US 5 055 966 A (SMITH HAL D [US] ET AL) 8 October 1991 (1991-10-08) * figure 7 * ----- | 1-13 | |
| A | US 5 972 231 A (DIBENE II JOSEPH T [US]) 26 October 1999 (1999-10-26) * figures 1,2 * ----- | 1-13 | |

**TECHNICAL FIELDS SEARCHED (IPC)**

H01L

The present search report has been drawn up for all claims

| Place of search | Date of completion of the search | Examiner |
|---|---|---|
| The Hague | 30 May 2023 | Kästner, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 20 9061

This annex lists the patent family members relating to the patent documents cited in the above-mentioned European search report.
The members are as contained in the European Patent Office EDP file on
The European Patent Office is in no way liable for these particulars which are merely given for the purpose of information.

30-05-2023

| Patent document cited in search report | | Publication date | Patent family member(s) | | Publication date |
|---|---|---|---|---|---|
| US 2016262260 | A1 | 08-09-2016 | JP | 5756958 B2 | 29-07-2015 |
| | | | JP | 2015082516 A | 27-04-2015 |
| | | | TW | 201532488 A | 16-08-2015 |
| | | | US | 2016262260 A1 | 08-09-2016 |
| | | | WO | 2015060216 A1 | 30-04-2015 |
| US 5055966 | A | 08-10-1991 | CA | 2056740 A1 | 18-06-1992 |
| | | | DE | 69108365 T2 | 05-10-1995 |
| | | | DK | 0491542 T3 | 06-06-1995 |
| | | | EP | 0491542 A1 | 24-06-1992 |
| | | | ES | 2069837 T3 | 16-05-1995 |
| | | | JP | 2874120 B2 | 24-03-1999 |
| | | | JP | H04299889 A | 23-10-1992 |
| | | | KR | 920013500 A | 29-07-1992 |
| | | | US | 5055966 A | 08-10-1991 |
| US 5972231 | A | 26-10-1999 | NONE | | |

EPO FORM P0459

For more details about this annex : see Official Journal of the European Patent Office, No. 12/82